Europäisches Patentamt

European Patent Office

Office européen des brevets

(19)

(11) Veröffentlichungsnummer : **0 017 130**
**B1**

(12) **EUROPÄISCHE PATENTSCHRIFT**

(45) Veröffentlichungstag der Patentschrift :
26.01.83

(21) Anmeldenummer : 80101553.8

(22) Anmeldetag : 24.03.80

(51) Int. Cl.³ : **H 04 L 27/22, H 03 L 7/06,**
**H 04 B 1/16**

(54) Empfänger für hochfrequente elektromagnetische Schwingungen mit einer Frequenznachregelung.

(30) Priorität : 02.04.79 DE 2913172

(43) Veröffentlichungstag der Anmeldung :
15.10.80 Patentblatt 80/21

(45) Bekanntmachung des Hinweises auf die Patenterteilung : 26.01.83 Patentblatt 83/04

(84) Benannte Vertragsstaaten :
**AT CH DE FR GB IT NL SE**

(56) Entgegenhaltungen :
DE B 1 933 290
US A 3 949 314

PHILIPS' TELECOMMUNICATION REVIEW, Vol. 36, No. 1, April 1978 Hilversun, the Netherlands S.W. Watkinson « A dual phase lock loop receiver », Seiten 5-12.
RUNDFUNKTECHNISCHE MITTEILUNGEN, 16. Jahrgang, 1972, Heft 5, Mensing Co ; Hamburg, München F. LOUIS, H. M. STUMPERS et al. « Ein Empfänger für Zweiseitenband-AM und für Einseitenband-AM mit teilweise unterdrücktem Träger », Seiten 202-206.

(73) Patentinhaber : SIEMENS AKTIENGESELLSCHAFT
Berlin und München Wittelsbacherplatz 2
D-8000 München 2 (DE)

(72) Erfinder : Gabler, Egmont, Ing. grad.
Scheidegger Strasse 8
D-8000 München 71 (DE)
Erfinder : Lehmann, Uwe, Dipl.-Ing.
Paula-Wimmer-Strasse 17
D-8060 Dachau (DE)

EP 0 017 130 B1

Empfänger für hochfrequente elektromagnetische Schwingungen mit einer Frequenznachregelung

Die Erfindung bezieht sich auf einen Empfänger für hochfrequente elektromagnetische Schwingungen mit einer Frequenznachregelung, die einen spannungsgesteuerten Oszillator enthält, wobei im Signalweg des Empfängers eine Phasenregelschleife (PLL : Phase-Looked Loop) für die Wiedergewinnung des Trägers eingeschaltet ist, mit einer Einrichtung zur Trägerrückgewinnung, einem phasenstarren Oszillator (PLL-Oszillator) und einem Phasendetektor, dem das Ausgangssignal der Trägerrückgewinnung und die Schwingungen des PLL-Oszillators als Referenzsignal zugeführt werden und dessen phasengeregeltes Ausgangssignal (Träger) der Frequenzregelschleife zugeführt wird.

Unerwünschte Frequenzschwankungen in Systemen werden meist durch Frequenzgegenkopplungsschaltungen unterdrückt. Hierfür kann im Gegenkopplungszweig ein Frequenzdiskriminator vorgesehen werden, der mit seiner verstärkten Ausgangsspannung einen die Signalfrequenz mitbestimmenden spannungsgesteuerten Oszillator, z.B. den Lokaloszillator eines Umsetzers, speist.

Die Frequenznachregelung unmodulierter oder schmalbandiger Signale ist relativ unkritisch. Besondere Probleme ergeben sich jedoch bei Breitbandsignalen, wie z.B. PSK-Signalen, bei denen wegen des fehlenden Trägers das gesamte Spektrum im Diskriminator bewertet werden muß. Hierbei können Regelungsfehler nicht nur durch instabile Frequenzdiskriminatoren, sondern zusätzlich auch durch nichtkonstante Amplitudenschräglagen auftreten.

Durch den Artikel « A dual phase lock loop receiver » von S.W. Watkinson, erschienen in Philips' Telecommunication Review, Vol. 36, N° 1, April 1978, ist ein Empfänger der eingangs beschriebenen Art bekannt. Bei diesem wird das demodulierte Signal nicht einem separaten synchronen Detektor, sondern unmittelbar dem Phase-Locked Loop entnommen.

Der Erfindung- liegt die Aufgabe zugrunde, einen Empfänger hür hochfrequente elektromagnetische Schwingungen mit einer Frequenznachregelung so auszubilden, daß auch bei Empfang breitbandiger Signale Regelungsfehler vermieden und ein Fangen der Regelschleife vorgenommen werden.

Diese Aufgabe wird bei einem Empfänger der einleitend genannten Art gemäß der Erfindung in der Weise gelöst, daß das Fangen der Frequenz- und Phasenregelschleife durch Einkoppeln einer externen Wobbelspannung erfolgt.

Durch die erfindungsgemäßen Maßnahmen, die sich besonders für Empfänger mit kohärenter Demodulation, z.B. PSK-Empfänger eignen, entstehen keine Restfehler durch Amplitudenverzerrungen. Darüberhinaus kann der Phasenregelkreis direkt als Frequenzdiskriminator für eine Frequenzregelschleife (AFC-Schleife) benutzt werden.

Vorteilhafte Ausgestaltungen und Weiterbildungen des Anmeldungsgegenstandes sind in den Unteransprüchen angegeben.

Nachstehend wird die Erfindung anhand von in der Zeichnung dargestellten Ausführungsbeispielen näher erläutert.

Es zeigen

Figur 1 das Blockschaltbild eines Empfängers mit der bekannten Frequenznachregelung und

Figur 2 ein entsprechendes Blockschaltbild wie in Fig. 1, bei dem zusätzlich die erfindungsgemäße Wobbelspannungseinkopplung enthalten ist.

Der Empfänger, insbesondere ein PSK-Empfänger, besteht aus einem Empfangsmischer 1, dem das Empfangssignal (RF-Signal) und die Schwingungen eines Lokaloszillators 2 zugeführt werden. Im Signalweg des Empfängers (ZF-Ebene) sind eine Schaltung 3 zur Trägerrückgewinnung, ein Phasendetektor 4 und ein Filter 5 (PLL-Schleifenfilger) in der genannten Reihenfolge eingeschaltet. Vom Ausgang des PLL-Schleifenfilters 5 führt die Frequenzregelschleife AFC über ein Filter 7 (AFC-Schleifenfilter) und einen Regelverstärker 8 zum Lokaloszillator 2, der mit dem Empfangsmischer 1 verbunden ist. Ferner ist an den Ausgang des PLL-Schleifenfilters 5 ein zur Phasenregelschleife (PLL-Schleife) gehörender PLL-Oszillator 6 angeschaltet, der mit dem Phasendiskriminator 4 und dem eigentlichen Demodulatorteil 9 verbunden ist, dessen zweiter Eingang an den Ausgang des Empfangsmischers 1 angeschlossen ist. Dem Ausgang des Demodulatorteils 9 sind digitale Daten (PSK-Signale) entnehmbar (Darstellung durch die Pfeile).

Der rückgewonnene Träger wird in einem PSK-Empfänger meist einer Phasenregelschleife (PLL-Schleife) zugeführt, um mit Hilfe des Schleifenfilters 5 die Phasenrauschbandbreite zu begrenzen. Als Ausgangssignal dient das Signal des PLL-Oszillators 6, das innerhalb der Schleifenfilterbandbreite ein genaues Abbild des wiedergewonnenen Trägers darstellt. Die hier gewonnene Referenz wird erst danach dem eigentlichen Demodulatorteil 9 zugeführt, damit durch Vergleich mit dem modulierten Eingangssignal die Phaseninformation gewonnen werden kann. Hierbei können auch Teile wie die Phasendiskriminatoren der Trägerrückgewinnung und Demodulatoren identisch sein. Im gerasteten Zustand ist die Oszillatorfrequenz $f_O$ des PLL-Oszillators 6 genau gleich der Eingangsfrequenz $f_E$ am Eingang des Phasendetektors 4 und damit die Spannung U am PLL-Oszillator 6 ein Maß für die Eingangsfrequenz gemäß der Kennlinie des PLL-Oszillators 6. Der Phasenregelkreis wirkt dabei als Frequenzdiskriminator und ist an die Frequenzregelschleife (AFC-Schleife) angeschlossen. Als Stabilitätsbedingung ergibt sich die Forderung, daß die Bandbreite der Frequenzregelschleife wesentlich kleiner als die Bandbreite der Phasenregelschleife sein muß, dementsprechend also das Filter 7 mit dem Frequenzgang $F_2(\omega)$ in der Frequenzregelschleife wesentlich schmalbandiger ist als das Filter 5 mit dem Frequenzgang $F_1(\omega)$ in der Phasenregelschleife.

Durch die Frequenzregelschleife wird für den Phasenregelkreis der günstigste Arbeitspunkt eingestellt, der bei einer Spannung von nahezu 0V am Phasendiskriminatorausgang gegeben ist. Dies ist besonders bei PSK-Demodulatoren wegen der hohen Schleifenbelastung durch die Trägerrückgewinnungsverfahren wichtig.

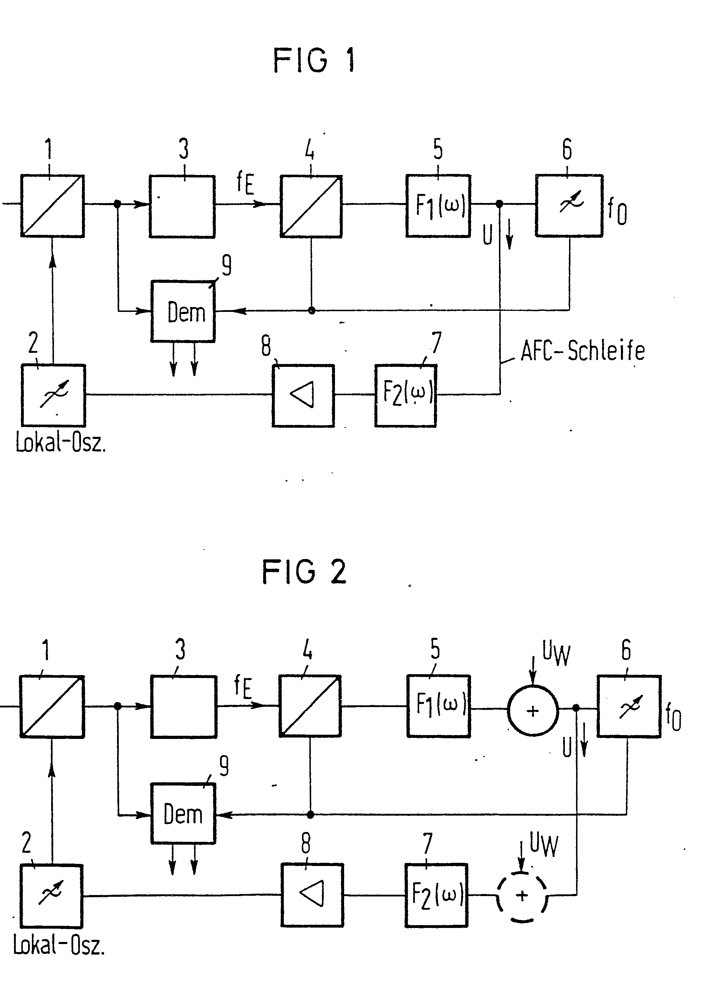

Fig. 2 zeigt das Blockschaltbild eines Empfängers, der in seinem Grundaufbau dem Empfänger nach Fig. 1 entspricht und bei dem die gleichen Elemente bzw. Bausteine mit gleichen Bezugzeichen versehen sind. Zusätzlich sind bei diesem Empfänger die erfindungsgemäßen Möglichkeiten zum Einkoppeln einer externen Wobbelspannung $U_W$ vorgesehen, durch die das Fangen der Regelschleifen vorgenommen wird. Es sind dabei zwei Möglichkeiten der Wobbelspannungseinkopplung vorgesehen, und zwar im einen Fall in der Phasenregelschleife (Kreis im Signalweg, an den der Pfeil mit der Bezeichnung $U_W$ geführt ist) und im anderen Fall in der Frequenzregelschleife (strichliert eingezeichneter Kreis). Es ist dabei wesentlich, daß mit der Wobbelspannung sowohl die Phasenregelschleife als auch die Frequenzregelschleife durchgesteuert werden, so daß zunächst die Phasenregelschleife und danach die Frequenzregelschleife einrasten können.


**Ansprüche**

1. Empfänger für hochfrequente elektromagnetische Schwingungen mit einer Frequenznachregelung, die einen spannungsgesteuerten Oszillator (2) enthält, wobei im Signalweg des Empfängers eine Phasenregelschleife (4, 5, 6) (PLL : Phase-Looked Loop) für die Wiedergewinnung des Trägers eingeschaltet ist, mit einer Einrichtung (3) zur Trägerrückgewinnung, einem phasenstarren Oszillator (PLL-Oszillator) (6) und einem Phasendetektor (4), dem das Ausgangssignal der Trägerrückgewinnung und die Schwingungen des PLL-Oszillators als Referenzsignal zugeführt werden und dessen phasengeregeltes Ausgangssignal (Träger) (U) der Frequenzregelschleife (1-5, 7, 8, 2) zugeführt wird, dadurch gekennzeichnet, daß das Fangen der Frequenz- und Phasenregelschleife durch Einkoppeln einer externen Wobbelspannung ($U_W$) erfolgt.

2. Empfänger nach Anspruch 1, dadurch gekennzeichnet, daß die Einkopplung der Wobbelspannung ($U_W$) in der Phasenregelschleife (4, 5, 6) erfolgt.

3. Empfänger nach Anspruch 1, dadurch gekennzeichnet, daß die Einkopplung der Wobbelspannung ($U_W$) in der Frequenzregelschleife (1-5, 7, 8, 2) erfolgt.

4. Empfänger nach einem der vorhergehenden Ansprüche, dadurch gekennzeichnet, daß das demodulierte Signal einem separaten synchronen Detektor (9) entnommen wird.


**Claims**

1. A receiver for high frequency electro-magnetic oscillations comprising a frequency re-adjustment unit which has a voltage-controlled oscillator (2), where a phase regulating loop (4, 5, 6) (PLL : Phase-Locked Loop) for the recovery of the carrier is connected in the signal path of the receiver, a device (3) for carrier recovery comprising a phase-locked oscillator (PLL-oscillator) (6) and a phase detector (4) to which are fed the carrier recovery output signal and the oscillations of the PLL-oscillator as reference signal, and whose phase-regulated output signal (carrier) (U) is fed to the frequency regulating loop (1-5, 7, 8, 2), characterised in that the capture of the frequency regulating loop and the phase regulating loop is effected by input coupling an external wobbulator voltage ($U_W$).

2. A receiver as claimed in Claim 1, characterised in that the input coupling of the wobbulator voltage ($U_W$) is effected in the phase regulating loop (4, 5, 6).

3. A receiver as claimed in Claim 1, characterised in that the input coupling of the wobbulator voltage ($U_W$) is effected in the frequency regulating loop (1-5, 7, 8, 2).

4. A receiver as claimed in one of the preceding Claims, characterised in that the demodulated signal is derived from a separate synchronous detector (9).


**Revendications**

1. Récepteur pour des ondes électromagnétiques à haute fréquence avec réajustement des fréquences, qui comporte un oscillateur commandé en tension (2), une boucle de régulation de phase (4, 5, 6) (PLL : phase Locked Loop) pour la régénération de la porteuse étant insérée dans le trajet de signaux du récepteur, boucle qui comporte un dispositif (3) pour la régénération de la porteuse, un oscillateur rigide en phase (oscillateur PLL) (6), et un détecteur de phase (4) auquel sont appliqués le signal de sortie de régénération de la porteuse et les oscillations de l'oscillateur (PLL) en tant que signal de référence, et dont le signal de sortie régulé en phase (porteuse) (U) est appliqué à la boucle de régulation de fréquences (1-5, 7, 8, 2), caractérisé par le fait que l'accrochage des boucles de régulation de fréquence et de phase a lieu par introduction d'une tension de wobulation externe ($U_W$).

2. Récepteur suivant la revendication 1, caractérisé par le fait que l'introduction de la tension de wobulation ($U_W$) a lieu dans la boucle de régulation de phase (4, 5, 6).

3. Récepteur suivant la revendication 1, caractérisé par le fait que l'introduction de la tension

de wobulation ($U_W$) a lieu dans la boucle de régulation de fréquence (1-5, 7, 8, 2).

4. Récepteur suivant l'une des revendications précédentes, caractérisé par le fait que le signal démodulé est prélevé sur un détecteur synchrone distinct (9).

## FIG 1

fE

F₁(ω) → $F_1(\omega)$

U

f₀ → $f_0$

Dem

F₂(ω) → $F_2(\omega)$

AFC-Schleife

Lokal-Osz.

## FIG 2

fE

$F_1(\omega)$

$U_W$

$U$

$f_0$

Dem

$F_2(\omega)$

$U_W$

Lokal-Osz.